# EUROPEAN PATENT SPECIFICATION

(11) **EP 2 887 453 B1**
(45) Date of publication and mention of the grant of the patent: **13.05.2020**
(21) Application number: 15154353.5
(22) Date of filing: 26.06.2014
(51) Int. Cl.: H01Q 1/24, H01Q 1/10, H01R 13/627, H01R 13/639, H01Q 1/52, H01R 24/52, H05K 1/02, H05K 9/00

(54) **Radio communication module**
Funkkommunikationsmodul
Module de communication radio

(30) Priority: 28.06.2013 KR 20130075653; 26.07.2013 KR 20130089057; 16.06.2014 KR 20140072918
(43) Date of publication of application: 24.06.2015
(62) Divisional of application: 14174581.0
(73) Proprietor: Samsung Electro-Mechanics Co., Ltd., Suwon-si, Gyeonggi-do 443-743 (KR)
(72) Inventor: Park, Hee Jun, Youngtong-Gu, Suwon-Si, Gyeonggi-Do 443-743 (KR); Oh, Hee Sun, Youngtong-Gu, Suwon-Si, Gyeonggi-Do 443-743 (KR); Lee, Gye Won, Youngtong-Gu, Suwon-Si, Gyeonggi-Do 443-743 (KR); Kim, Jong Yun, Youngtong-Gu, Suwon-Si, Gyeonggi-Do 443-743 (KR)
(74) Representative: Keenway Patentanwälte Neumann Heine Taruttis

(56) References cited:
- EP-A1- 1 598 944
- US-A1- 2002 175 879
- US-A1- 2004 110 417
- US-A1- 2013 149 887

## Description

### CROSS-REFERENCE TO RELATED APPLICATION

This application claims the benefit of Korean Patent Application No. 10-2013-0075653, filed on June 28, 2013, Korean Patent Application No. 10-2013-0089057, filed on July 26, 2013 and Korean Patent Application No. 10-2014-0072918, filed on June 16, 2014, entitled "Radio Communication Module".

### BACKGROUND

The present disclosure relates to a radio communication module.

Wi-Fi generally is a wireless local area network (WLAN) technology enabling high performance radio communication by combining a wireless technology with High fidelity. Here, the WLAN means a scheme of building a network using an electric wave, light, or the like, without using a wire at the time of building the network.

Therefore, a radio communication module in the Wi-Fi is possible is used, such that a product for consumer electronics (CE) including a set-top box, a television (TV), a printer, and a notebook computer may be wirelessly connected and used.

Here, the product for CE includes an antenna (ANT) playing an important role in performance of the Wi-Fi. Generally, the antenna is connected to the radio communication module using a UFL connector.

However, in the case in which the antenna (ANT) is simply connected to the radio communication module, when abnormal impact is applied from the outside to the product for CE having the radio communication module embedded therein, a detaching phenomenon occurs, such that the antenna (ANT) may be separated from the radio communication module.

In order to solve this problem, KR10-0730085 B1has disclosed that in mounting an antenna connector on a printed circuit board of a radio communication module and then connecting a radio frequency (RF) cable connector to the antenna connector to connect an antenna to the radio communication module, a protrusion and a groove are formed in the antenna connector and the RF cable connector, respectively, and are coupled to each other to prevent the antenna from being separated from the radio communication module.

In addition, a hole is drilled in the printed circuit board, and a cable of the antenna passes through the hole to prevent detachment of the antenna, or the cable is soldered to the printed circuit board to prevent detachment of the antenna. However, in this scheme, workability is significantly decreased at the time of mass production, and an additional process is required, which causes a cost increase.

From US 2004/0110417 A1 an electrical connector assembly is known for permanently coupling of a first connector with a second connector that cooperate to form the electrical connector assembly. The connectors are shaped shell like and the first connector is in the connected state surrounded by the second connector to ensure that only a small surface of the respective printed circuit board is occupied by the connector assembly. A connection is only caused in one single location. Further reference is made to EP 1 598 944 A1 (which discloses a tuner comprising a shield can and at least one connector. At least of the connectors is used to connect an antenna), US 2002/175879 A1 and US 2013/149887 A1.

### SUMMARY

An aspect of the present disclosure is to solve a problem that an antenna is separated from a radio communication module when abnormal impact is generated.

That is, an aspect of the present disclosure provides a radio communication module from which separation of an antenna may be easily prevented.

The radio communication module according to the invention is defined by claim 1.

That is, the radio communication module according to an aspect of the present disclosure may have various circuit devices, or the like, mounted therein for Wi-Fi connection by way of example, and includes a printed circuit board including a receiving connector, an antenna connected to the printed circuit board through a transmitting connector connected to the receiving connector, and a shield can provided on the printed circuit board and shielding an electromagnetic wave.

Here, the radio communication module may be embedded and used in, for example, an electronic product for consumer electronics (CE) including a set-top box (STB), a television (TV), a printer, or the like.

The receiving connector and the transmitting connector, which are components connecting the antenna corresponding to a necessary component of the radio communication module to the printed circuit board, may be generally a UFL connector.

In addition, the shield can, which is formed of a metal including aluminum and is to protect various circuit devices, or the like, mounted on the printed circuit board through electromagnetic wave shielding due to characteristics of this metal, prevents the transmitting connector from being detached from the receiving connector together with the electromagnetic wave shielding.

To this end, in an example not forming part of the invention, the shield can may include a blocking part formed at one side surface thereof and protruding toward the transmitting connector and the receiving connector. Here, the blocking part may be disposed adjacently to the transmitting connector regardless of a height of the shield can, and may include a reinforcing structure formed in order to reinforce strength and a support structure formed in order to prevent a distal end thereof from sagging.

Therefore, in the radio communication module according to an aspect of the present disclosure, separation of the antenna due to a detachment phenomenon may be easily prevented as compared with a radio communication module according to the related art, such that work efficiency may be improved and deterioration of performance may be prevented.

Alternatively, the transmitting connector may include latching parts formed toward the printed circuit board and the shield can, respectively, and fixing parts to which the latching parts are coupled may be formed in the printed circuit board and the shield can, respectively.

Here, the latching part may be coupled to the fixing part formed in the printed circuit board or the shield can by an elastic action due to characteristics of a material thereof to prevent detachment of the transmitting connector. The latching part may be partially or entirely rounded so that this elastic action may be easily performed.

Therefore, in the radio communication module according to the present invention, a coupling feature between the transmitting connector and the receiving connector may be improved as compared with a radio communication module according to the related art, thereby preventing a detachment problem between the transmitting connector and the receiving connector in advance. In addition, through this, a ground may be reinforced to increase stability of a signal.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a partially enlarged front view of a radio communication module according to a first example;
FIG. 2 is a plan view generally showing the radio communication module according to the first example;
FIG. 3 is a plan view generally showing a radio communication module according to a second example;
FIG. 4 is a partially enlarged front view of a radio communication module according to a third example;
FIG. 5 is a partially enlarged front view of a radio communication module according to a fourth example;
FIG. 6 is a partially enlarged front view of a radio communication module according to a fifth example;
FIG. 7 is a partially enlarged cross-sectional view of a radio communication module according to a sixth example;
FIG. 8 is a plan view generally showing the radio communication module according to the sixth example;
FIG. 9 is a partially enlarged cross-sectional view of a radio communication module according to a first embodiment of the present invention;
FIG. 10 is a plan view generally showing the radio communication module according to the first embodiment of the present invention;
FIG. 11 is a partially enlarged cross-sectional view of a radio communication module according to a second embodiment of the present invention; and
FIG. 12 is a plan view generally showing the radio communication module according to the second embodiment of the present invention.

### DETAILED DESCRIPTION

The objects, features and advantages of the present disclosure will be more clearly understood from the following detailed description of the exemplary embodiments and descriptive examples not covered by the enclosed claim set taken in conjunction with the accompanying drawings. Throughout the accompanying drawings, the same reference numerals are used to designate the same or similar components, and redundant descriptions thereof are omitted. Further, in the following description, the terms "first," "second," "one side," "the other side" and the like are used to differentiate a certain component from other components, but the configuration of such components should not be construed to be limited by the terms. Further, in the description of the present disclosure, when it is determined that the detailed description of the related art would obscure the gist of the present disclosure, the description thereof will be omitted.

Hereinafter, exemplary embodiments of the present invention and descriptive examples not covered by the enclosed claim set will be described in detail with reference to the accompanying drawings.

### [First Example]

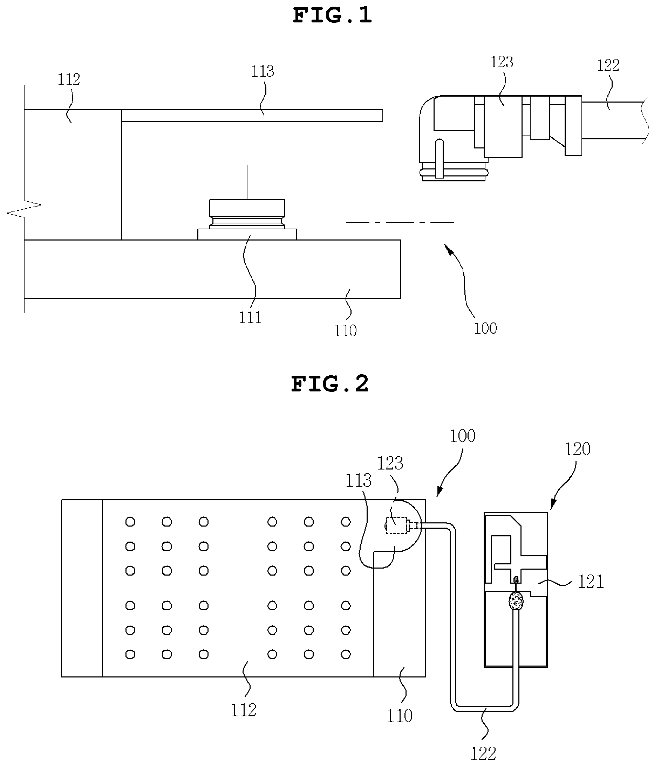

As shown in FIGS. 1 and 2, a radio communication module 100 according to a first example is configured to include a printed circuit board 110 including a receiving connector 111, a shield can 112 provided on the printed circuit board 110 and shielding an electromagnetic wave, an antenna 120 including a transmitting connector 123 connected to the receiving connector 111, and a blocking part 113 formed at a side of one side surface of the shield can 112 so as to protrude toward the transmitting connector 123 and the receiving connector 111.

The printed circuit board 110 includes a general UFL connector mounted as the receiving connector 111 on a substrate and the shield can 112 installed at one side of the receiving connector 111 and made of a metal, the blocking part 113 is formed at a side of the right of the shield can 112 in FIGS. 1 and 2.

The antenna 120 is configured of a kind of module by connecting a UFL connector formed in a circular shape using a thin copper plate as the transmitting connector 123 to a front end of a cable 122 and soldering and mounting the other end of the cable 122 to and on an antenna board 121.

Therefore, in the radio communication module 100 according to the first example, the blocking part 113 protruding at one side surface of the shield can 112 is disposed above the transmitting connector 123 and the receiving connector 111 at the time of connecting the transmitting connector 123 to the receiving connector 111, thereby making it possible to easily prevent the transmitting connector 123 from being detached from the receiving connector 111. As a result, separation of the antenna 120 is effectively prevented to prevent deterioration of performance.

### [Second Example]

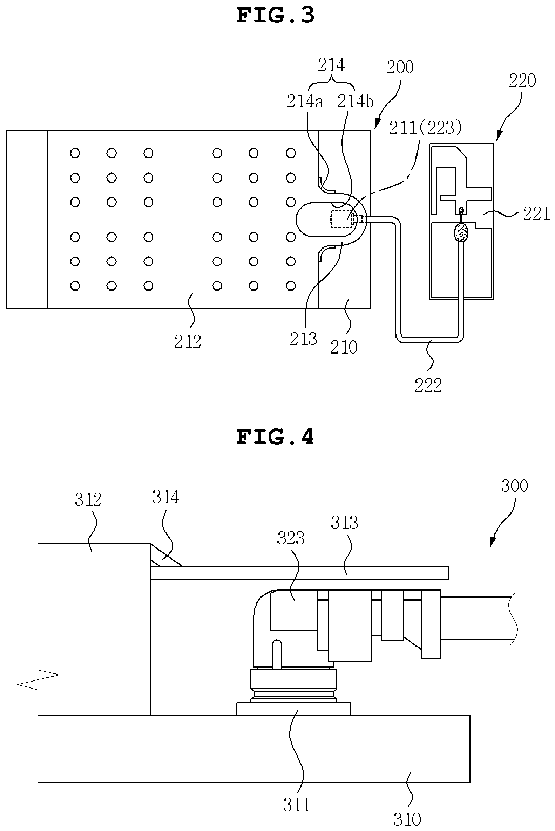

As shown in FIG. 3, a radio communication module 200 according to a second example is configured to include a printed circuit board 210 including a receiving connector 211, a shield can 212 provided on the printed circuit board 210 and shielding an electromagnetic wave, an antenna 220 including a transmitting connector 223 connected to the receiving connector 211, and a blocking part 213 formed at a central portion of one side surface of the shield can 212 so as to protrude toward the transmitting connector 223 and the receiving connector 211.

The printed circuit board 210 includes a general UFL connector mounted as the receiving connector 211 on a substrate and the shield can 212 installed at one side of the receiving connector 211 and made of a metal, and the blocking part 213 is formed at the center of the right of the shield can 212 in FIG. 3.

The antenna 220 is configured of a kind of module by connecting a UFL connector formed in a circular shape using a thin copper plate as the transmitting connector 223 to a front end of a cable 222 and soldering and mounting the other end of the cable 222 to and on an antenna board 221.

Meanwhile, a distal end of the left of the blocking part 213 in FIG. 3 is connected to an upper portion of the shield can 212. However, a sag phenomenon occurs due to absence of a connection structure at a distal end of the right of the blocking part 213 to cause electric wave interference due to a contact between the blocking part 213 and the transmitting connector 223 or generate breaking, or the like, due to a contact between the blocking part 213 and a peripheral apparatus. Therefore, a reinforcing part 214 is formed in order to reinforce strength.

That is, the reinforcing part 214, which is to structurally reinforce the strength of the blocking part 213 generally formed of a thin plate, includes a rib 214a formed at an outer portion at which the shield can 212 and the blocking part 213 are connected to each other. As an example, the rib 214a is integrally formed and protrudes at one side surfaces of the shielding can 212 and the blocking part 213 in a process of pressing and forming the shield can 212 to prevent the sag, the breaking, or the like, of the blocking part 213.

In addition, the reinforcing part 214 may be formed in the blocking part 214, which may be easily implemented by bending a portion of a plate in a direction toward the printed circuit board 210 or a direction opposite to the direction toward the printed circuit board 210 in a process of forming the blocking part 213 to form a concave-convex part 214b. That is, the concave-convex part 214b formed by structurally bending the blocking part 213 formed of a thin plate prevents the sag or the breaking of the blocking part 213.

Here, the reinforcing part 213 may include any one of the rib 214a and the concave-convex part 214b or include both of them.

Therefore, in the radio communication module 200 according to the second example, the strength of the blocking part 213 connected to the upper portion of the shield can 212, protruding at one side surface of the shield can 212, and disposed above the transmitting connector 223 and the receiving connector 211 to easily prevent the transmitting connector 223 from being detached from the receiving connector 211 may be structurally easily reinforced by the reinforcing part 214. As a result, separation of the antenna 220 due to an external factor is effectively prevented to prevent deterioration of performance.

### [Third Example]

As shown in FIG. 4, a radio communication module 300 according to a third example is configured to include a printed circuit board 310 including a receiving connector 311, a shield can 312 provided on the printed circuit board 310 and shielding an electromagnetic wave, an antenna (ANT) including a transmitting connector 323 connected to the receiving connector 311, and a blocking part 313 formed at a central portion of one side surface of the shield can 312 so as to protrude toward the transmitting connector 323 and the receiving connector 311.

Here, the antenna (ANT) is substantially the same as the antenna according to the first example described above. Therefore, the antenna (ANT) is not shown in FIG. 4, and a detailed description of the antenna (ANT) will be omitted.

The printed circuit board 310 includes a general UFL connector mounted as the receiving connector 311 on a substrate and the shield can 312 installed at one side of the receiving connector 311 and made of a metal, and the blocking part 313 is formed at the center of the right of the shield can 312 in FIG. 4.

The blocking part 313 is formed integrally with a bent part 314 bent downwardly from an edge of the shield can 312 toward the printed circuit board 310 in consideration of a height difference between the shield can 312 and the transmitting and receiving connectors 323 and 311, such that it is configured so as to be adjacent to upper portions of the transmitting and receiving connectors 323 and 311.

Therefore, in the radio communication module 300 according to the third example, the blocking part 313 is disposed adjacently to the upper portion of the transmitting connector 323 connected to the receiving connector 311, thereby making it possible to easily prevent the transmitting connector 323 from being detached from the receiving connector 311. As a result, separation of the antenna (ANT) is effectively prevented to prevent deterioration of performance.

### [Fourth Example]

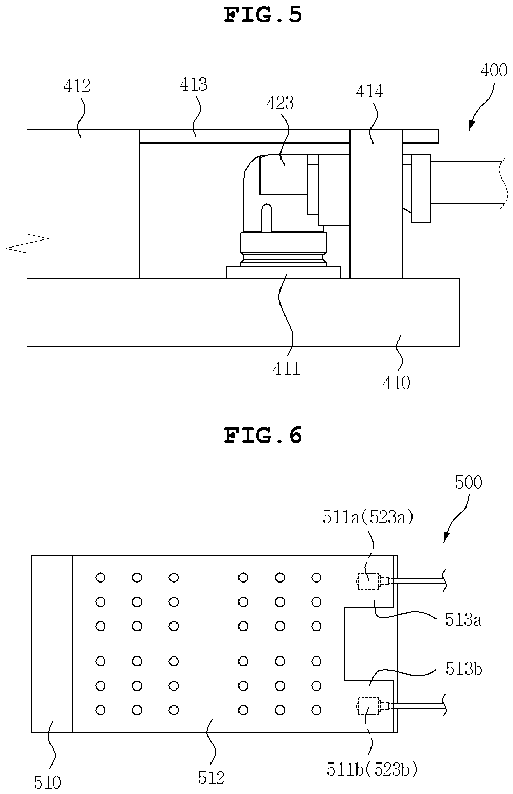

As shown in FIG. 5, a radio communication module 400 according to a fourth example is configured to include a printed circuit board 410 including a receiving connector 411, a shield can 412 provided on the printed circuit board 410 and shielding an electromagnetic wave, an antenna (ANT) including a transmitting connector 423 connected to the receiving connector 411, and a blocking part 413 formed at a central portion of one side surface of the shield can 412 so as to protrude toward the transmitting connector 423 and the receiving connector 411.

Here, the antenna (ANT) is substantially the same as the antenna according to the first example described above. Therefore, the antenna (ANT) is not shown in FIG. 5, and a detailed description of the antenna (ANT) will be omitted.

The printed circuit board 410 includes a general UFL connector mounted as the receiving connector 411 on a substrate and the shield can 412 installed at one side of the receiving connector 411 and made of a metal, and the blocking part 413 is formed at the center of the right of the shield can 412 in FIG. 5.

In addition, a distal end of the left of the blocking part 413 in FIG. 5 is connected to the shield can 412. However, a sag phenomenon occurs due to absence of a connection structure at a distal end of the right of the blocking part 413, thereby making it possible to cause electric wave interference due to a contact between the blocking part 413 and the transmitting connector 423. Therefore, a support part 414 bent toward the printed circuit board 410 is formed at a side surface of the blocking part 413.

Therefore, in the radio communication module 400 according to the fourth example, the blocking part 413 may prevent detachment of the transmitting connector 423 connected to the receiving connector 411, and the sag of the blocking part 413 may be easily prevented. As a result, deterioration of performance is effectively prevented.

### [Fifth Example]

As shown in FIG. 6, a radio communication module 500 according to a fifth example is configured to include a printed circuit board 510 including receiving connectors 511a and 511b, a shield can 512 provided on the printed circuit board 510 and shielding an electromagnetic wave, an antenna (ANT) including transmitting connectors 523a and 523b connected to the receiving connectors 511a and 511b, respectively, and blocking parts 513a and 513b formed at both sides of one side surface of the shield can 512, respectively, so as to protrude toward the receiving connectors 511a and 511b and the transmitting connectors 523a and 523b.

Here, the antenna (ANT) is substantially the same as the antenna according to the first example described above except that the number thereof is plural. Therefore, the antenna (ANT) is not shown in FIG. 5, and a detailed description of the antenna (ANT) will be omitted.

The printed circuit board 510 includes a plurality of general UFL connectors mounted as the receiving connectors 511a and 511b on a substrate and the shield can 512 installed at one sides of the receiving connectors 511a and 511b and made of a metal, and the blocking parts 513a and 513b are formed at both sides of the right of the shield can 512 in FIG. 6 so as to be spaced apart from each other.

Therefore, in the radio communication module 500 according to the fifth example, the blocking parts 513a and 513b protruding on both sides of the shield can 512, respectively, are disposed above the transmitting connectors 523a and 523b, respectively, at the time of connecting the plurality of transmitting connectors 523a and 523b to the plurality receiving connectors 511a and 511b, thereby making it possible to easily prevent the transmitting connectors 523a and 523b from being detached from the receiving connectors 511a and 511b, respectively. As a result, reliability depending on connecting and using the plurality of antennas (ANTs) to the printed circuit board 510 may be improved.

### [Sixth Example]

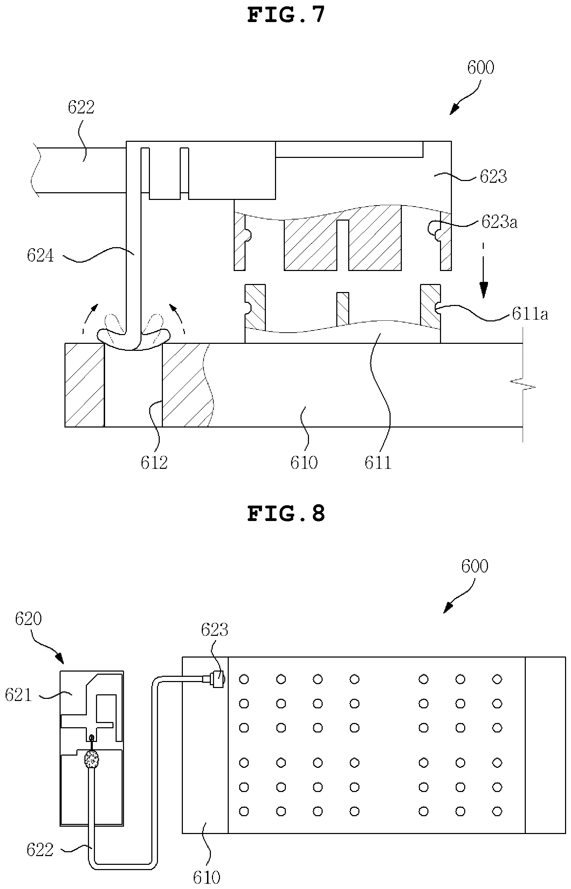

As shown in FIGS. 7 and 8, a radio communication module 600 according to a sixth example is configured to include a printed circuit board 610 including a receiving connector 611, an antenna 620 including a transmitting connector 623 connected to the receiving connector 611, and a latching part 624 formed at the transmitting connector 623 and coupled to a fixing part 612 formed in the printed circuit board 610.

The printed circuit board 610 includes a general UFL connector mounted as the receiving connector 611 on a substrate and a hole formed as the fixing part 612 at one side of the receiving connector 611 to allow the latching part 624 to be inserted thereinto and coupled thereto.

The antenna 620 is configured by soldering and mounting one end of a cable 622 to and on an antenna board 621 and connecting a UFL connector formed in a circular shape using a thin copper plate as the transmitting connector 623 to the other end of the cable 622. Here, the latching part 624 having a front end divided into two parts and rounded is formed below the transmitting connector 623 in a protrusion form.

Therefore, the latching part 624 is inserted into the fixing part 612 formed in the printed circuit board 610 by an elastic action due to characteristics of a material thereof in a process of connecting the transmitting connector 623 to the receiving connector 611 provided on the printed circuit board 610 and is then coupled and fixed to a lower portion of the printed circuit board 610 while returning to its original form.

Here, the latching part 624 is coupled to the lower portion of the printed circuit board 610 while generating a kind of 'click' sound in a process in which it returns to its original form. A worker may easily decide whether the transmitting connector 623 has been coupled through this sound.

Therefore, in the radio communication module 600 according to the sixth example including the latching part 624, detachment of the transmitting connector 623 from the receiving connector 611 may be easily prevented, and the transmitting connector 623 serves as a ground (GND) on a circuit due to a ground with the printed circuit board 610, thereby making it possible to provide a ground reinforcing effect.

Meanwhile, a coupling protrusion 623a may be formed on an inner surface of the transmitting connector 623 and a coupling groove 611a having a position and a size corresponding to those of the coupling protrusion 623a may be formed in an outer surface of the receiving connector 611 to prevent, together with the latching part 624, detachment of the transmitting connector 623.

### [First Embodiment]

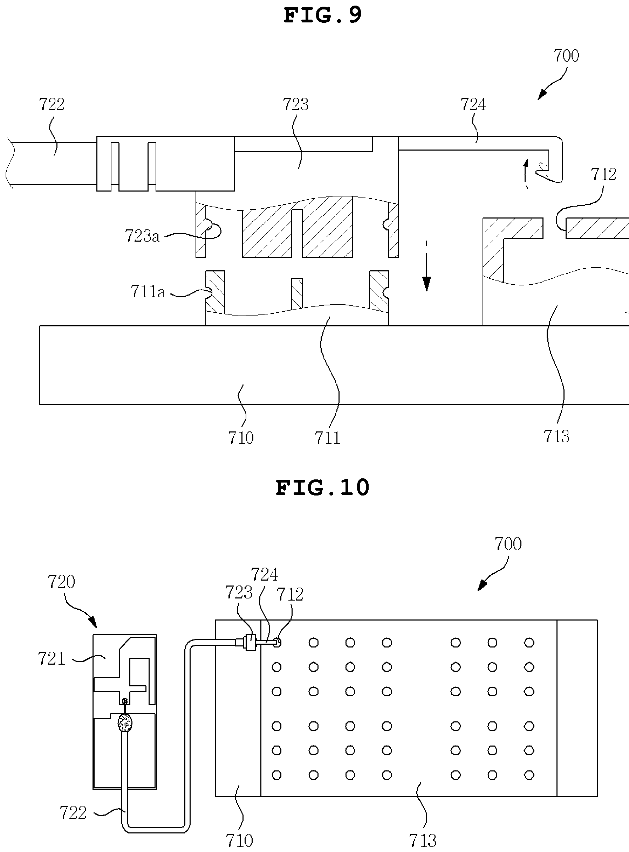

As shown in FIGS. 9 and 10, a radio communication module 700 according to a first embodiment of the present invention is configured to include a printed circuit board 710 including a receiving connector 711, a shield can 713 provided on the printed circuit board 710 and shielding an electromagnetic wave, an antenna 720 including a transmitting connector 723 connected to the receiving connector 711, and a latching part 724 formed at the transmitting connector 723 and coupled to a fixing part 712 formed in the shield can 713.

The printed circuit board 710 includes a general UFL connector mounted as the receiving connector 711 on a substrate and the shield can 713 installed at one side of the receiving connector 711 and made of a metal, and a hole is formed as the fixing part 712 above the shield can 713 to allow the latching part 724 to be inserted thereinto and coupled thereto.

The antenna 720 is configured by soldering and mounting one end of a cable 722 to and on an antenna board 721 and connecting a UFL connector formed in a circular shape using a thin copper plate as the transmitting connector 723 to the other end of the cable 722. Here, the latching part 724 having a front end rounded downwardly is formed at an upper end of a side surface of the transmitting connector 723 in a protrusion form.

Therefore, the latching part 724 is inserted into the fixing part 712 formed in the shield can 713 by an elastic action due to characteristics of a material thereof in a process of connecting the transmitting connector 723 to the receiving connector 711 provided on the printed circuit board 710 and is then coupled and fixed to an inner portion of the shield can 713 while returning to its original form.

Here, the latching part 724 is coupled to the inner portion of the shield can 713 while generating a kind of 'click' sound in a process in which it returns to its original form. A worker may easily decide whether the transmitting connector 723 has been coupled through this sound.

Therefore, in the radio communication module 700 according to the first embodiment of the present invention including the latching part 724, detachment of the transmitting connector 723 from the receiving connector 711 may be easily prevented, and the transmitting connector 723 serves as a ground (GND) on a circuit due to a ground with the shield can 713, thereby making it possible to provide a ground reinforcing effect.

Meanwhile, a coupling protrusion 723a may be formed on an inner surface of the transmitting connector 723 and a coupling groove 711a having a position and a size corresponding to those of the coupling protrusion 723a may be formed in an outer surface of the receiving connector 711 to prevent, together with the latching part 724, detachment of the transmitting connector 723.

### [Second Embodiment]

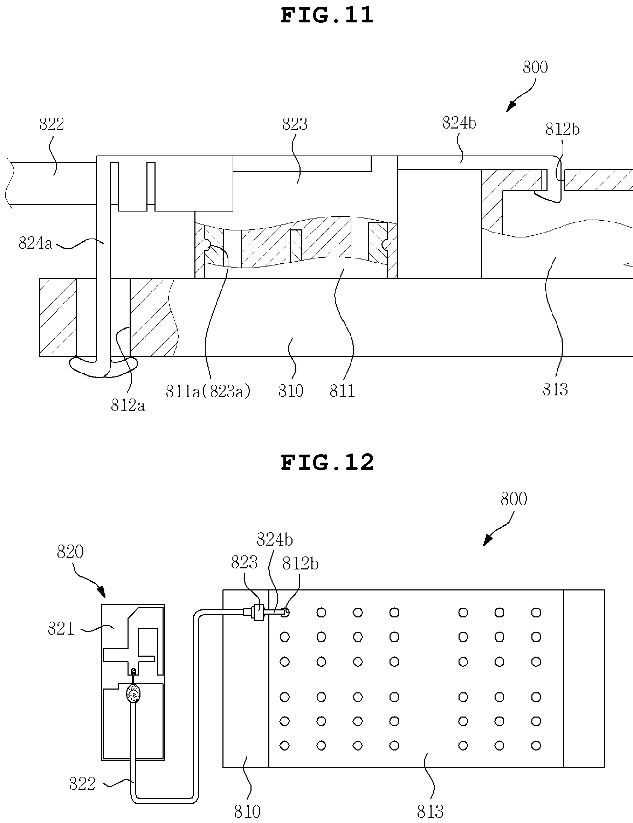

As shown in FIGS. 11 and 12, a radio communication module 800 according to a second embodiment of the present disclosure is configured to include a printed circuit board 810 including a receiving connector 811, a shield can 813 provided on the printed circuit board 810 and shielding an electromagnetic wave, an antenna 820 including a transmitting connector 823 connected to the receiving connector 811, and latching parts 824a and 824b formed at the transmitting connector 823 and coupled to fixing parts 812a and 812b formed in the printed circuit board 810 and the shield can 813, respectively.

Here, for easiness of explanation and convenience of understanding, the latching part coupled to the printed circuit board 810 will be called a first latching part 824a, the latching part 824 coupled to the shield can 813 will be called a second latching part 824b, the fixing part formed in the printed circuit board 810 will be called a first fixing part 812a, and the fixing part formed in the shield can 813 will be called a second fixing part 812b.

The printed circuit board 810 includes a general UFL connector mounted as the receiving connector 811 on a substrate and a hole formed as the first fixing part 812a at one side of the receiving connector 811 to allow the first latching part 824a to be inserted thereinto and coupled thereto. In addition, the shield can 813 made of a metal is installed at one side of the receiving connector 811, and a hole is formed as the second fixing part 812b above the shield can 813 to allow the second latching part 824b to be inserted thereinto and coupled thereto.

The antenna 820 is configured by soldering and mounting one end of a cable 822 to and on an antenna board 821 and connecting a UFL connector formed in a circular shape using a thin copper plate as the transmitting connector 823 to the other end of the cable 822.

Here, the first latching part 824a having a front end divided into two parts and rounded is formed below the transmitting connector 823 in a protrusion form. In addition, the second latching part 824b having a front end rounded downwardly is formed at an upper end of a side surface of the transmitting connector 823 in a protrusion form.

Therefore, the first latching part 824a is inserted into the first fixing part 812a formed in the printed circuit board 810 by an elastic action due to characteristics of a material thereof in a process of connecting the transmitting connector 823 to the receiving connector 811 provided on the printed circuit board 810 and is then coupled and fixed to a lower portion of the printed circuit board 810 while returning to its original form. In addition, the second latching part 824b is inserted into the second fixing part 812b formed in the shield can 813 and is then coupled and fixed to an inner portion of the shield can 813 while returning to its original form.

Here, the first and second latching parts 824a and 824b are coupled to the inner portion of the shield can 813 while generating a kind of 'click' sound in a process in which it returns to its original form. A worker may easily decide whether the transmitting connector 823 has been coupled through this sound.

Therefore, in the radio communication module 800 according to the second embodiment of the present invention including the first and second latching parts 824a and 824b, detachment of the transmitting connector 823 from the receiving connector 811 may be easily prevented, and the transmitting connector 823 serves as a ground (GND) on a circuit due to a ground with the printed circuit board 810 and the shield can 813, thereby making it possible to provide a ground reinforcing effect.

Meanwhile, a coupling protrusion 823a may be formed on an inner surface of the transmitting connector 823 and a coupling groove 811a having a position and a size corresponding to those of the coupling protrusion 823a may be formed in an outer surface of the receiving connector 811 to prevent, together with the first and second latching parts 824a and 824b, detachment of the transmitting connector 823.

## Claims

1. A radio communication module (700, 800) comprising:
a printed circuit board (710, 810) including a receiving connector (711, 811);
a shield can (713, 813) provided on the printed circuit board (700, 800) and shielding an electromagnetic wave; and
an antenna (720, 820) including a transmitting connector (723, 823) connected to the receiving connector (711, 811) and connected to the printed circuit board (700. 800) through the transmitting connector (723, 823),
wherein the shield can (713, 813) includes a fixing part (712, 812b), and the transmitting connector includes a latching part (724, 824b) configured to be insertedly coupled to the fixing part (712, 812b).

2. The radio communication module (700, 800) of claim 1, wherein the antenna (720, 820) includes:
the transmitting connector (723, 823);
a cable (722, 822) connected to the transmitting connector (723, 823); and
an antenna board (721, 821) having the cable (722, 822) mounted thereon.

3. The radio communication module (700, 800) of claim 1, wherein the fixing part (712, 812v) is a hole having the latching part (724, 824b) inserted thereinto and coupled thereto.

## Patentansprüche

1. Ein Funkkommunikationsmodul (700, 800) umfassend:
eine Leiterplatte (710, 810) mit einem Empfangsanschluss (711, 811);
eine Abschirmdose (713, 813), die auf der Leiterplatte (700, 800) vorgesehen ist und eine elektromagnetische Welle abschirmt; und
eine Antenne (720, 820) mit einem Sendeanschluss (723, 823), der mit dem Empfangsanschluss (711, 811) verbunden und über den Sendeanschluss (723, 823) mit der Leiterplatte (700. 800) verbunden ist,
wobei die Abschirmungsdose (713, 813) ein Befestigungsteil (712, 812b) enthält und der Sendeanschluss ein Verriegelungsteil (724, 824b) enthält, das konfiguriert ist, um mit dem Befestigungsteil (712, 812b) durch Einsetzen verbunden zu werden.

2. Funkkommunikationsmodul (700, 800) nach Anspruch 1, wobei die Antenne (720, 820) umfasst: den Sendeanschluss (723, 823), ein Kabel (722, 822), das mit dem Sendeanschluss (723, 823) verbunden ist; und eine Antennenplatine (721, 821), auf der das Kabel (722, 822) montiert ist.

3. Funkkommunikationsmodul (700, 800) nach Anspruch 1, wobei das Befestigungsteil (712, 812v) ein Loch ist, in das das Verriegelungsteil (724, 824b) eingesetzt und damit gekoppelt ist.

## Revendications

1. Module de radiocommunication (700, 800) comprenant :
une carte de circuit imprimé (710, 810) comportant un connecteur de réception (711, 811) ;
un boîtier de blindage (713, 813) prévu sur la carte de circuit imprimé (700, 800) et servant à protéger une onde électromagnétique ; et
une antenne (720, 820) comportant un connecteur de transmission (723, 823) connecté au connecteur de réception (711, 811) et connecté à la carte de circuit imprimé (700, 800) par le connecteur de transmission (723, 823),
le boîtier de blindage (713, 813) comportant une partie de fixation (712, 812b), et le connecteur de transmission comportant une partie de verrouillage (724, 824b) conçue pour être accouplée par insertion à la partie de fixation (712, 812b).

2. Module de radiocommunication (700, 800) selon la revendication 1, dans lequel l'antenne (720, 820) comporte :
le connecteur de transmission (723, 823) ;
un câble (722, 822) connecté au connecteur de transmission (723, 823) ; et
une carte d'antenne (721, 821) sur laquelle est monté le câble (722, 822).

3. Module de radiocommunication (700, 800) selon la revendication 1, dans lequel la partie de fixation (712, 812v) est un trou dans lequel est insérée, et auquel est accouplée, la partie de verrouillage (724, 824b).
